# EUROPEAN PATENT SPECIFICATION

(11) **EP 4 510 609 B1**
(45) Date of publication and mention of the grant of the patent: **18.02.2026**
(21) Application number: 24181407.8
(22) Date of filing: 11.06.2024
(51) Int. Cl.: H04Q 9/00

(54) **BATTERY SYSTEM AND OPERATING METHOD OF BATTERY MANAGEMENT SYSTEM**
BATTERIESYSTEM UND BETRIEBSVERFAHREN FÜR EIN BATTERIEVERWALTUNGSSYSTEM
SYSTÈME DE BATTERIE ET PROCÉDÉ DE FONCTIONNEMENT DE SYSTÈME DE GESTION DE BATTERIE

(30) Priority: 14.08.2023 KR 20230106357
(43) Date of publication of application: 19.02.2025
(73) Proprietor: SAMSUNG SDI CO., LTD., Giheung-gu Yongin-si, Gyeonggi-do 17084 (KR); Seoul National University R&DB Foundation, Seoul 08826 (KR)
(72) Inventor: Kang, Dongyoun, Yongin-si, Gyeonggi-do 17084 (KR); Yoo, Jiwon, Yongin-si, Gyeonggi-do 17084 (KR); Cho, Namik, Seoul 06305 (KR); Jo, Junho, Incheon 21966 (KR); Lee, Keuntek, Anyang-si, Gyeonggi-do 14101 (KR); Youn, Seokjun, Seoul 06578 (KR)
(74) Representative: Gulde & Partner

(56) References cited:
- EP-A1- 4 206 713
- WO-A1-2023/112371

## Description

### CROSS-REFERENCE TO RELATED APPLICATION

### BACKGROUND

### 1. Field

One or more embodiments relate to a battery system, and more specifically, to a battery system that compresses and transmits data collected from battery cells by using a Huffman algorithm, and an operating method of a battery management system.

### 2. Description of the Related Art

Recently, secondary batteries have been used in a variety of ways, such as energy storage systems and electric vehicles (EVs). An energy storage system improves energy efficiency and enables stable operation of a power system by storing power when demand for power is low and using the stored power when demand for power is high. Recently, as the spread of smart grids and new and renewable energy has expanded and the efficiency and stability of power systems have been emphasized, the demand for energy storage systems is increasing to control power supply and demand and improve power quality, and energy storage systems are becoming increasingly large in capacity.

Meanwhile, as driving range has become an important purchasing factor for electric vehicles, larger-capacity battery packs are being installed in electric vehicles. Accordingly, the number of battery cells mounted on a battery pack is increasing. For example, WO 2023/112371 A1 describes a battery data transmission device for detecting the states of a plurality of battery cells and transmitting, via a transmission path, battery data regarding the detected plurality of battery cells, the device being provided with: an encoding unit that has a plurality of encoding modes and encodes battery data into encoded data; a mode selection unit for selecting any one encoding mode from the plurality of encoding modes; and a transmission control unit for transmitting, to a battery management device, the encoded data in the encoding mode selected by the mode selection unit, and receiving, from the battery management device, reception information on the transmitted data. EP 4 206 713 A1 discloses a battery diagnosis apparatus, a battery pack, an electric vehicle and a battery diagnosis method for diagnosing anomalies in a single battery cell or each of a plurality of battery cells connected in series using time-dependent changes in cell voltage of each battery cell without a process of comparing the cell voltage of each battery cell with the cell voltage of other battery cell(s).

In order to manage battery cells reliably, battery systems such as energy storage systems or electric vehicle battery packs are structured hierarchically. In a battery system, a lower controller measures voltage and temperature of battery cells and transmits the measurements to an upper controller. As the number of battery cells increases, there are cases in which the size of data to be transmitted to the upper controller exceeds the transmission speed.

### SUMMARY

The present invention is set out in the appended set of claims, wherein the drawings and respective description relate to advantageous embodiments thereof.

The present invention is directed to a battery system including a plurality of battery cells, a lower controller configured to collect cell voltages of the plurality of battery cells at each sampling period of a plurality of sampling periods, calculate, based on the cell voltages, an average cell voltage and cell voltage deviations, encode the cell voltage deviations into first bit codes by using a first cell voltage Huffman code table, and transmit the average cell voltage and the first bit codes at each sampling period of the plurality of sampling periods, and an upper controller configured to receive the average cell voltage and the first bit codes from the lower controller, decode the first bit codes into decoded cell voltage deviations by using a second cell voltage Huffman code table, and generate restored cell voltages of the plurality of battery cells by using the average cell voltage and the decoded cell voltage deviations. At least one of the upper controller and the lower controller is configured to estimate, based on a size of transmission data including the first bit codes at each sampling period of the plurality of sampling periods, a degree of aging of the plurality of battery cells.

In embodiments the battery system may further include a lower memory in which the first cell voltage Huffman code table readable by the lower controller may be stored in advance and an upper memory in which the second cell voltage Huffman code table readable by the upper controller may be stored in advance.

In embodiments, the battery system may further include a module controller configured to sense the cell voltages of the plurality of battery cells at each sampling period of the plurality of sampling periods and transmit sensed cell voltages to the lower controller.

In embodiments, the first cell voltage Huffman code table and the second cell voltage Huffman code table may store the same first bit code for a cell voltage deviation as each other.

In embodiments, the first and second cell voltage Huffman code tables may be such that a maximum error may be the same or increases as an absolute value of the cell voltage deviation increases.

In embodiments, the first and second cell voltage Huffman code tables may be configured to perform lossless compression if the cell voltage deviation may be between a first reference value less than 0 and a second reference value greater than 0.

In embodiments, the first and second cell voltage Huffman code tables may be asymmetrical such that a speed at which the maximum error may increase on average if the cell voltage deviation may be less than 0 may be slower than a speed at which the maximum error increases on average if the cell voltage deviation is greater than 0.

In embodiments, the lower controller may be configured to collect cell temperatures of the plurality of battery cells at each sampling period of the plurality of sampling periods, calculate, based on the cell temperatures, an average cell temperature and cell temperature deviations, encode the cell temperature deviations into second bit codes by using a first cell temperature Huffman code table, and transmit the average cell temperature and the second bit codes to the upper controller at each sampling period of the plurality of sampling periods, and the upper controller may be configured to receive the average cell temperature and the second bit codes from the lower controller, decode the second bit codes into decoded cell temperature deviations by using the second cell temperature Huffman code table, and generate restored cell temperatures of the plurality of battery cells by using the average cell temperature and the decoded cell temperature deviations.

In embodiments, the battery system may include a lower memory in which the first cell temperature Huffman code table readable by the lower controller may be stored in advance and an upper memory in which the second cell temperature Huffman code table readable by the upper controller may be stored in advance.

In embodiments, wherein the first cell temperature Huffman code table and the second cell temperature Huffman code table may store a same second bit code for a cell temperature deviation as each other.

In embodiments, the first and second cell temperature Huffman code tables may be symmetrical such that a maximum error is the same or increases as an absolute value of the cell temperature deviation increases.

The present invention is also directed to an operating method of a battery management system including a lower controller and an upper controller, the method including collecting, by the lower controller, cell voltages of a plurality of battery cells at each sampling period of a plurality of sampling periods, based on the cell voltages, calculating, by the lower controller, an average cell voltage and cell voltage deviations, encoding, by the lower controller, the cell voltage deviations into first bit codes by using a first cell voltage Huffman code table stored in advance, transmitting, by the lower controller, the average cell voltage and the first bit codes to the upper controller at each sampling period of a plurality of sampling periods, receiving, by the upper controller, the average cell voltage and the first bit codes from the lower controller, decoding, by the upper controller, the first bit codes into decoded cell voltage deviations by using a second cell voltage Huffman code table stored in advance, and generating, by the upper controller, restored cell voltages of the plurality of battery cells by using the average cell voltage and the decoded cell voltage deviations at each sampling period. At least one of the upper controller or the lower controller stores the average cell voltage at each sampling period, stores a size of transmission data including the first bit codes at each sampling period of the plurality of sampling periods and estimates a degree of aging of the plurality of battery cells, based on the size of the transmission data.

In embodiments, the first cell voltage Huffman code table and the second cell voltage Huffman code table may store the same first bit code for a cell voltage deviation as each other.

In embodiments, the method may further include collecting, by the lower controller, cell temperatures of the plurality of battery cells at each sampling period of the plurality of sampling periods, based on the cell temperatures, calculating, by the lower controller, an average cell temperature and cell temperature deviations, encoding, by the lower controller, the cell temperature deviations into second bit codes by using the first cell temperature Huffman code table stored in advance, transmitting, by the lower controller, the average cell temperature and the second bit codes to the upper controller at each sampling period of the plurality of sampling periods, receiving, by the upper controller, the average cell temperature and the second bit codes from the lower controller, decoding, by the upper controller, the second bit codes into decoded cell temperature deviations by using the second cell temperature Huffman code table stored in advance and generating, by the upper controller, restored cell temperatures of the plurality of battery cells by using the average cell temperature and the decoded cell temperature deviations for each sampling period.

In embodiments, the first cell temperature Huffman code table and the second cell temperature Huffman code table may store the same second bit code for a cell temperature deviation as each other.

### BRIEF DESCRIPTION OF THE DRAWINGS

Features will become apparent to those of skill in the art by describing in detail exemplary embodiments with reference to the attached drawings in which:
FIG. 1 is a schematic diagram of a configuration of a battery system according to embodiments;
FIG. 2 is a diagram showing a configuration of a battery system centered on one battery, according to embodiments;
FIG. 3 is a diagram of a detailed configuration of a battery management system according to embodiments;
FIG. 4 is a diagram for explaining an operating method of a battery management system according to embodiments;
FIG. 5A is a diagram showing characteristics of a cell voltage Huffman code table used in a battery management system according to embodiments;
FIG. 5B is an enlarged view of a portion of FIG. 5A.
FIG. 6 shows a detailed configuration of a battery management system according to other embodiments;
FIG. 7 is a diagram for explaining an operating method of a battery management system according to other embodiments;
FIG. 8A is a diagram showing characteristics of a cell temperature Huffman code table used in a battery management system according to embodiments;
FIG. 8B is an enlarged view of a portion of FIG. 8A; and
FIG. 9 is a diagram showing a detailed configuration of a battery management system according to other embodiments.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

In the description of the drawings, like reference numerals have been used for like elements. In the accompanying drawings, dimensions of structures may be exaggerated or reduced than actual sizes for clarity.

The terms used herein are for the purpose of describing particular embodiments only and are not intended to be limiting of the disclosure. The singular forms include the plural forms unless the context clearly indicates otherwise. In the present disclosure, terms such as "include" or "have" are intended to designate the existence of listed features, but it should be understood that it does not preclude the possibility of the presence or addition of one or more other features, numbers, steps, operations, components, parts, or combinations thereof. In the present disclosure, the term "and/or" may be used to include any and all combinations of features listed together. In the present disclosure, the terms "first" and "second", etc., may be used herein to describe various features and to distinguish one feature from other features, and, these features should not be limited by these terms. In the following description, when an element is referred to as being "on" another element, this includes not only a case when one element is located directly above another element, but also a case when another element is disposed therebetween.

Unless defined otherwise, all terms used herein, including technical or scientific terms, have the same meaning as commonly understood by one of ordinary skill in the art to which various embodiments of the present disclosure belong. Terms such as those defined in commonly used dictionaries should be interpreted as having a meaning consistent with the meaning in the context of the related art, and unless explicitly defined in various embodiments of the present disclosure, the terms are not to be construed in an idealized or overly formal sense.

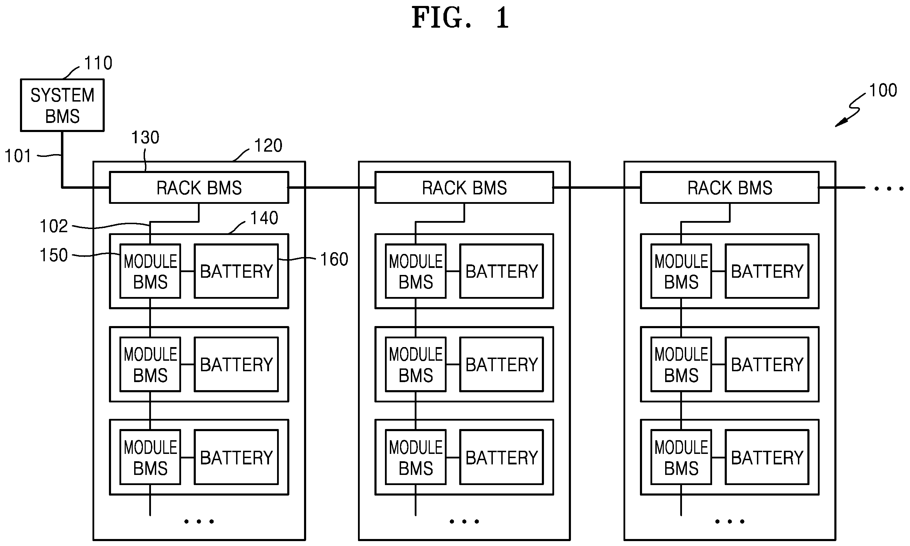

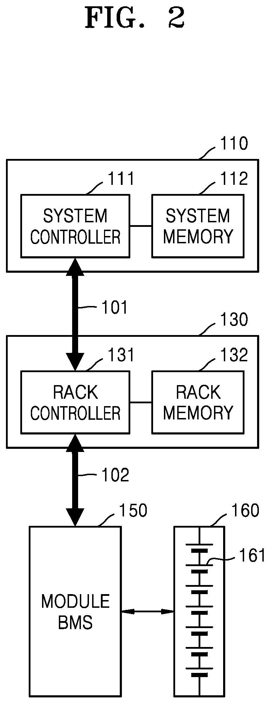

FIG. 1 is a schematic diagram of a configuration of a battery system 100 according to embodiments. FIG. 2 is a diagram showing a configuration of the battery system 100 centered on one battery, according to embodiments.

Referring to FIGS. 1 and 2, the battery system 100 includes a plurality of battery racks 120 and a battery management system (BMS) 110 configured to manage the entire battery system 100. The battery rack 120 includes a plurality of battery modules 140 and a rack BMS 130 configured to manage the battery rack 120. The battery module 140 includes a battery 160 including a plurality of battery cells 161 and a module BMS 150 that manages the battery 160.

In embodiments, the battery system 100 may include an energy storage system. According to another example, the battery system may be a battery pack of an electric vehicle. Hereinafter, embodiments of the present disclosure will be described assuming that the battery system 100 is an energy storage system.

The battery 160, as a part for storing power, outputs electrical energy to the outside when discharging, and stores electrical energy input from the outside when charging. Each battery 160 may include a plurality of battery cells 161 connected in series, parallel, or a combination of series and parallel. The number of battery cells 161 included in the battery 160 may be determined according to the required output voltage and storage capacity.

The batteries 160 may be connected to each other in series, parallel, or a combination of series and parallel. For example, the batteries 160 included in one battery rack 120 may be connected to each other in series, and the battery racks 120 may be connected to each other in parallel.

The battery cell 161 may include a rechargeable secondary battery. For example, the battery cell 161 may be a lithium-ion battery, a lithium polymer battery, a nickel-cadmium battery, or a nickel metal hydride (NiMH) battery, a lead acid battery, or the like.

The system BMS 110, the rack BMS 130, and the module BMS 150 hierarchically constitute the battery management system of the battery system 100. As shown in FIG. 1, the system BMS 110 may transmit and receive data to and from a plurality of rack BMSs 130 through a network 101. The rack BMS 130 may transmit and receive data with the plurality of module BMSs 150 through a network 102. The network 101 and the network 102 may be separate from each other or may be part of the same network. A controller area network (CAN) communication may be performed between the system BMS 110 and the plurality of rack BMSs 130. The CAN communication may also be performed between the rack BMS 130 and a plurality of module BMS 150.

The module BMS 150 may monitor the status of the battery 160 assigned to the module BMS 150, that is, the battery 160 may be included in the same battery module 150, and may perform an operation of cell balancing of the battery cells 161, etc. The module BMS 150 may measure a cell voltage and a cell temperature of the battery cells 161 and transmit the measured cell voltage and the cell temperature of the battery cells 161 to the rack BMS 130. The module BMS 150 may perform a cell balancing function according to the control of the rack BMS 130.

The rack BMS 130 may collect a cell voltage and a cell temperature of the battery cells 161 included in the battery rack 120 through the module BMS 150, and may provide the collected data of the battery cells 161 to the system BMS 110. The rack BMS 130 may transmit a cell balancing command to the module BMS 150 to which the corresponding battery cell may be assigned to perform cell balancing with respect to the battery cells having a cell voltage higher or lower than a reference value compared to other battery cells 161. The rack BMS 130 may measure a total voltage and a charge/discharge current of the battery rack 120. The rack BMS 130 may estimate the state of charge (SOC) and state of health (SOH) of the batteries 160 or the battery cells 161, and may control a contactor (not shown) if detecting a preset event.

The system BMS 110 may receive data of the battery cells 161 from the plurality of lower-level rack BMSs 130, may control the battery rack 120 based on the received data, and may transmit data of the battery system 100 to an upper-level system, such as an energy management system (EMS) and a power control system (PCS).

The system BMS 110 and the plurality of rack BMSs 130 may communicate via CAN-Bus, and may communicate at a transmission speed of 500 kbps considering the maximum distance between the system BMS 110 and the plurality of rack BMSs 130. The system BMS 110 and the plurality of rack BMS 130 may also increase transmission speed by using two CAN-Bus.

The module BMS 150 may measure a cell voltage and a cell temperature of the battery cells 161 in the battery 160 at each preset sampling period, and may transmit the measured cell voltage and the cell temperature to the rack BMS 130. The module BMS 150 may include a voltage sensor and a temperature sensor to measure a cell voltage and a cell temperature of the battery cells 161.

The rack BMS 130 may collect cell voltages and cell temperatures of the battery cells 161 in the battery rack 120 through the module BMS 150. The rack BMS 130 may collect cell voltages and cell temperatures of the battery cells 161 at each sampling period.

The rack BMS 130 may calculate an average cell voltage and cell voltage deviations based on the cell voltages of the battery cells 161, may encode the cell voltage deviations into first bit codes using the first cell voltage Huffman code table, and may transmit the average cell voltage and the first bit codes to the system BMS 110 at each sampling period.

The system BMS 110 may receive the average cell voltage and the first bit codes from the rack BMS 130, may decode the first bit codes into decoded cell voltage deviations using the second cell voltage Huffman code table, and may generate restored cell voltages of the battery cells 161 using the average cell voltage and the decoded the cell voltage deviations.

As shown in FIG. 2, the system BMS 110 may include a system controller 111 and a system memory 112, and the rack BMS 130 may include a rack controller 131 and a rack memory 132. Because the system BMS 110 and the rack BMS 130 may be hierarchically configured, the system controller 111 may be referred to as an upper controller, and the rack controller 131 may be referred to as a lower controller. According to another example, the rack controller 131 may be the upper controller, and the module BMS 150 may be the lower controller. According to another example, the system controller 111 may be the upper controller and the module BMS 150 may be the lower controller.

The rack BMS 130 may estimate an aging degree of the batteries 160 included in the battery rack 120 at each sampling period based on a size of data transmitted to the system BMS 110. The data transmitted to the system BMS 110 at each sampling period may include first bit codes.

The system BMS 110 may estimate an aging degree of the batteries 160 included in the battery rack 120 corresponding to the rack BMS 130 at each sampling period based on a size of data received from the rack BMS 130. The data received from the rack BMS 130 at each sampling period may include first bit codes.

The rack BMS 130 may calculate the average cell temperature and cell temperature deviations based on the cell temperatures of the battery cells 161, may encode the cell temperature deviations into second bit codes using the first cell temperature Huffman code table, and may transmit the average cell temperature and the second bit codes to the system BMS 110 at each sampling period.

System BMS 110 may receive an average cell temperature and the second bit codes from the rack BMS 130, may decode the second bit codes into cell temperature deviations using the second cell temperature Huffman code table, and may generate restored cell temperatures of the battery cells 161 using the average cell temperature and the cell temperature deviations.

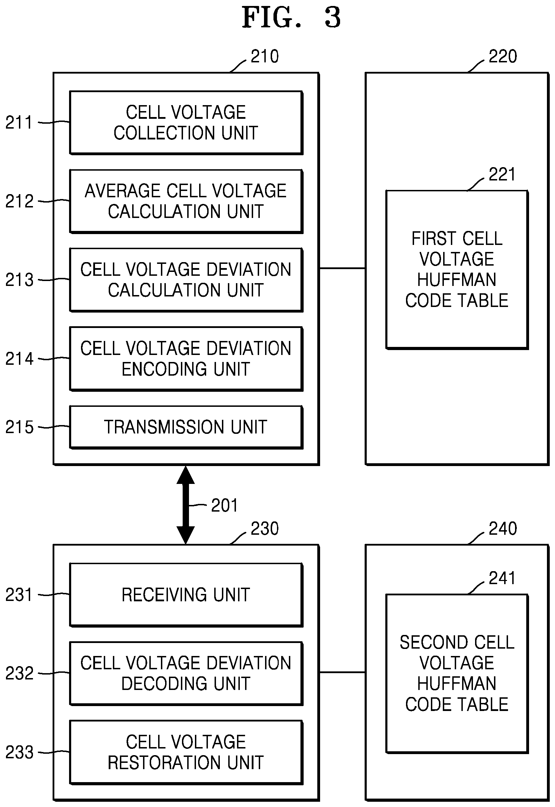

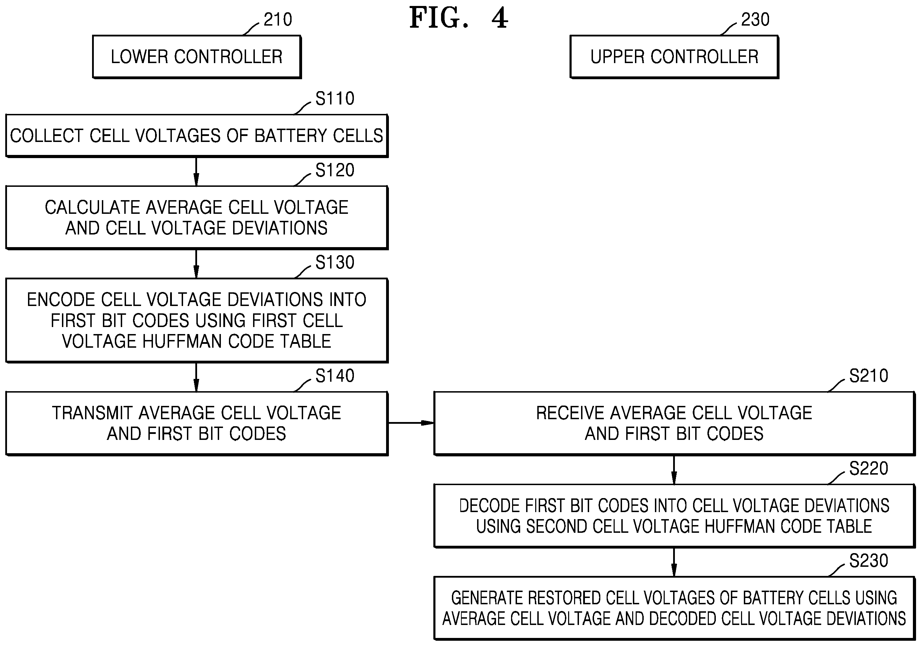

FIG. 3 is a diagram of a detailed configuration of a battery management system according to embodiments. FIG. 4 is a diagram for explaining a method of operating a battery management system according to embodiments.

Referring to FIGS. 3 and 4, a lower controller 210 and an upper controller 230 may perform data communication through a network 201. The network 201 may include a CAN-bus. The lower controller 210 may read data stored in the lower memory 220, and the upper controller 230 may read data stored in the upper memory 240.

The lower controller 210 and lower memory 220 may be included in the rack BMS (130 in FIG. 1), and the upper controller 230 and upper memory 240 may be included in the system BMS (110 in FIG. 1). According to another example, the lower controller 210 and the lower memory 220 may be included in the module BMS (150 in FIG. 1), and the upper controller 230 and the upper memory 240 may be included in the rack BMS 130. According to another example, the lower controller 210 and lower memory 220 may be included in the module BMS 150, and the upper controller 230 and upper memory 240 may be included in the system BMS 110.

The lower controller 210 includes a cell voltage collection unit 211, an average cell voltage calculation unit 212, a cell voltage deviation calculation unit 213, a cell voltage deviation encoding unit 214, and a transmission unit 215. The first cell voltage Huffman code table 221 may be stored in advance in the lower memory 220. The first cell voltage Huffman code table 221 may be readable by the lower controller 210.

The cell voltage collection unit 211 may collect cell voltages of battery cells 161 (refer to FIG. 1) at each sampling period (S110). According to one example, the module BMSs 150 (refer to FIG. 1) may measure cell voltages of the battery cells 161 at each sampling period, and the cell voltage collection unit 211 may receive cell voltages of the battery cells 161 from the module BMSs 150 at each sampling period. According to another example, the cell voltage collection unit 211 may directly measure the cell voltages of battery cells 161 (refer to FIG. 1) at each sampling period.

The sampling period may be, for example, 10 msec. According to another example, the sampling period may be shorter than 10 msec, for example between 1 and 9 msec, preferably between 2 to 5 msec, more preferred 1 msec, or longer than 10 msecs, for example 20 to 100 msec, preferably 50 to 100 msec, more preferred 100 msec.

The average cell voltage calculation unit 212 may calculate an average cell voltage based on cell voltages of the battery cells 161, and the cell voltage deviation calculation unit 213 may calculate cell voltage deviations of the battery cells 161 by subtracting the average cell voltage from each of the cell voltages of the battery cells 161 (S120).

The cell voltage deviations may be distributed centered zero, e.g., the distribution of cell voltage deviations may be centered at zero. For example , the cell voltage deviations may be distributed similar to a Gaussian distribution. However, if the average cell voltage of the battery cells 161 is low enough that the state of charge of the battery cells 161 is close to 0, the cell voltage deviations may be widely distributed in a negative (-) direction. That is, the standard deviation of negative (-) cell voltage deviations may be greater than the standard deviation of positive (+) cell voltage deviations.

The cell voltage deviation encoding unit 214 may encode the cell voltage deviations into first bit codes using the first cell voltage Huffman code table 221 stored in the lower memory 220 (S130).

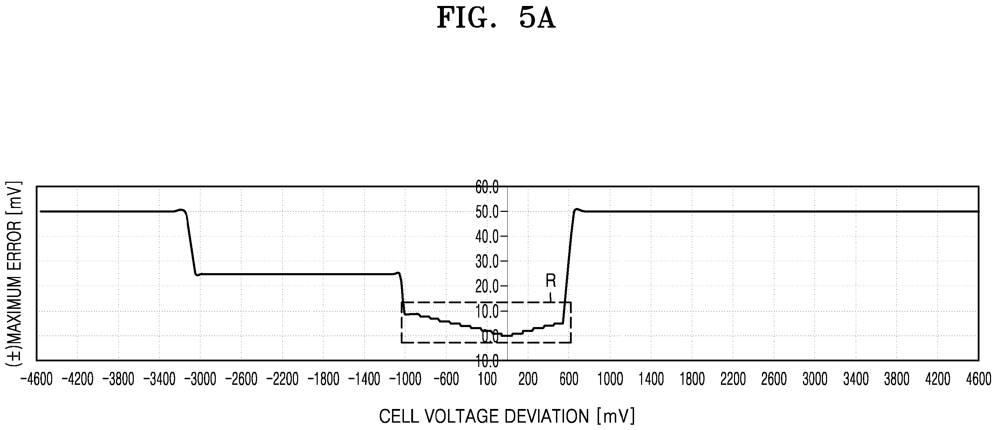

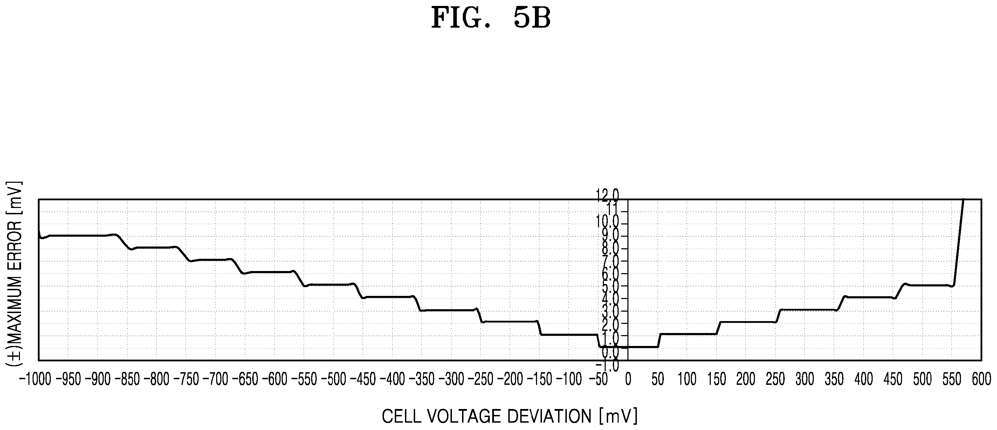

The first cell voltage Huffman code table 221 may be a table in which first bit code values for cell voltage deviation values may be stored, and may be configured such that a frequently occurring cell voltage deviation value corresponds to a short first bit code value. Because the cell voltage deviations may be distributed similarly to a Gaussian distribution, a first bit code value corresponding to a cell voltage deviation value of 0 may be the shortest. As an absolute value of the cell voltage deviation value increases, a length of the first bit code value corresponding to the cell voltage deviation value may become greater. The first cell voltage Huffman code table 221 will be described in more detail below with reference to FIGS. 5A and 5B.

Cell voltages may be expressed in 16 bits. The first bit code may be expressed as 1 bit to several tens of bits. However, because the cell voltage deviations may have a distribution similar to a Gaussian distribution, most of the first bit codes encoded cell voltage deviations may be expressed in several bits. If cell voltage deviations calculated from actual cell voltages are encoded into first bit codes, the first bit codes may have an average length of 4.79 bits. Because cell voltages of 16-bit may be compressed into 4.79-bit first bit codes, a compression ratio may be approximately 30%.

The transmission unit 215 may transmit an average cell voltage calculated by the average cell voltage calculation unit 212 and first bit codes generated by the cell voltage deviation encoding unit 214 to the upper controller 230 (S140).

The upper controller 230 includes a receiving unit 231, a cell voltage deviation decoding unit 232, and a cell voltage restoration unit 233. A second cell voltage Huffman code table 241 may be stored in advance in the upper memory 240. The second cell voltage Huffman code table 241 may be readable by the upper controller 230.

The receiving unit 231 may receive the average cell voltage and the first bit codes from the lower controller 210 (S210).

The cell voltage deviation decoding unit 232 may decode the first bit codes into cell voltage deviations using the second cell voltage Huffman code table 241 stored in the upper memory 240 (S220). The second cell voltage Huffman code table 241 may be the same as the first cell voltage Huffman code table 221. The first and second cell voltage Huffman code tables 221 and 241 may store the same first bit code for the cell voltage deviation as each other. The second cell voltage Huffman code table 241 may be the first cell voltage Huffman code table 221 received by the upper controller 230 from the lower controller 210 and stored in the upper memory 240.

The cell voltage deviations generated by decoding the first bit codes by the cell voltage deviation decoding unit 232 may exactly match the cell voltage deviations calculated from the cell voltages of the battery cells 161 by the cell voltage deviation calculation unit 213, but some may have certain errors. The first and second cell voltage Huffman code tables 221 and 241 may be configured to be losslessly compressed if the cell voltage deviation value is within a predetermined range. The predetermined range may be between a first reference value less than 0 and a second reference value greater than 0. If the cell voltage deviation value is outside the predetermined range, a certain error may occur between a cell voltage deviation value calculated by the cell voltage deviation calculation unit 213 and the cell voltage deviation value generated by the cell voltage deviation decoding unit 232, but the size of the error may be less than a maximum error. The first and second cell voltage Huffman code tables 221 and 241 may be configured such that the maximum error remains the same or increases as an absolute value of the cell voltage deviation increases.

The cell voltage restoration unit 233 may generate restored cell voltages of the plurality of battery cells 161 using an average cell voltage and decoded cell voltage deviations (S230). As described above, the restored cell voltages of the battery cells 161 may be mostly the same as the cell voltages of the battery cells 161, and even if an error occurs between the cell voltages of the battery cells 161, the restored cell voltages of the battery cells 161 may be less than or equal to a preset maximum error.

Accordingly, by encoding and transmitting the cell voltage deviations into first bit codes rather than transmitting the cell voltage values as is, the size of data to be transmitted may be greatly reduced. For example, if 484 cell voltage values are directly transmitted, data of 7.744 kbit should be transmitted, but if the first bit codes are encoded and transmitted using the cell voltage Huffman code table (221, 241) according to the present disclosure, the first bit codes may be transmitted as data of 2.334kbit. Because the size of data to be transmitted may be reduced by approximately 30%, the sampling period may be reduced to 0.3 times even if the transmission speed is maintained. That is, if the sampling period was 10 msec, the sampling period may be reduced to 3 msec according to the present disclosure.

According to another example, if the number of battery racks 120 included in the battery system 100 was 6, according to the present disclosure, the number of battery racks 120 to be included in the battery system 100 may be increased to 20.

FIG. 5A is a diagram showing characteristics of a cell voltage Huffman code table used in a battery management system according to embodiments, and FIG. 5B is an enlarged view of a portion R of FIG. 5A.

Referring to FIGS. 5A and 5B, the maximum error for cell voltage deviation, which is a characteristic of the cell voltage Huffman code table, is shown.

The cell voltage Huffman code tables 221 and 241 may be configured such that the maximum error remains the same or increases as an absolute value of the cell voltage deviation increases.

The cell voltage Huffman code tables 221 and 241 may be configured to perform lossless compression if the cell voltage deviation is between a first reference value less than 0 and a second reference value greater than 0. Referring to FIG. 5B, the first reference value may be -50 mV and the second reference value may be 50 mV.

If the cell voltage deviation is -150 mV to -50 mV, the maximum error between a cell voltage and a restored cell voltage may be 1 mV. In addition, if the cell voltage deviation is 50 mV to 150 mV, the maximum error between the cell voltage and the restored cell voltage may be 1 mV.

If the cell voltage deviation is -250 mV to -150 mV or 150 mV to 250 mV, the maximum error between the cell voltage and the restored cell voltage may be 2 mV. If the cell voltage deviation is - 350 mV to -250 mV or 250 mV to 350 mV, the maximum error between the cell voltage and the restored cell voltage may be 3 mV. In this way, as the absolute value of the cell voltage deviation increases, the maximum error may remain the same or increase.

The cell voltage Huffman code tables 221 and 241 may be configured such that the maximum error according to the cell voltage deviation has left and right asymmetry. For example, when the average cell voltage of the battery cells 161 is low, the cell voltage deviations may be widely distributed in a negative (-) direction, and thus, the cell voltage Huffman code tables 221 and 241 may be asymmetrically configured such that an average speed at which the maximum error increases if the cell voltage deviation is less than 0 may be lower than a speed at which the maximum error increases if the cell voltage deviation is greater than 0.

For example, when the cell voltage deviation is less than -3000 mV, the maximum error may be 50 mV, while if the cell voltage deviation exceeds 550 mV, the maximum error may be 50 mV. In addition, within a cell voltage deviation range from -1000 mV to 0 mV, the maximum error may increase from 0 mV to 10 mV as the cell voltage deviation decreases, while within a cell voltage deviation range from 0 mV to 550 mV, the maximum error may increase from 0 mV to 5 mV, and if the cell voltage deviation exceeds 550 mV, the maximum error may significantly increase to 50 mV.

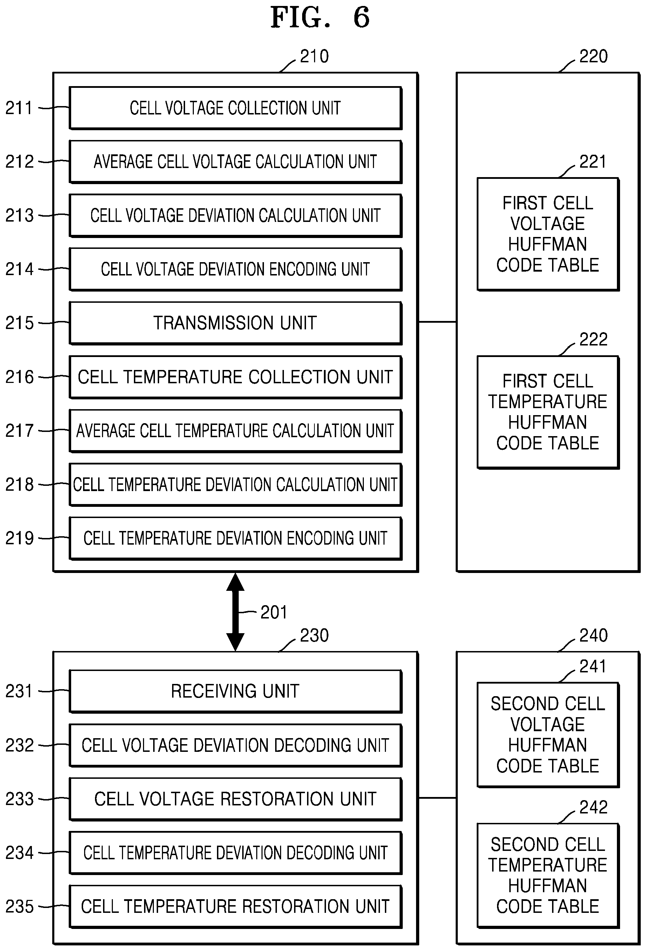

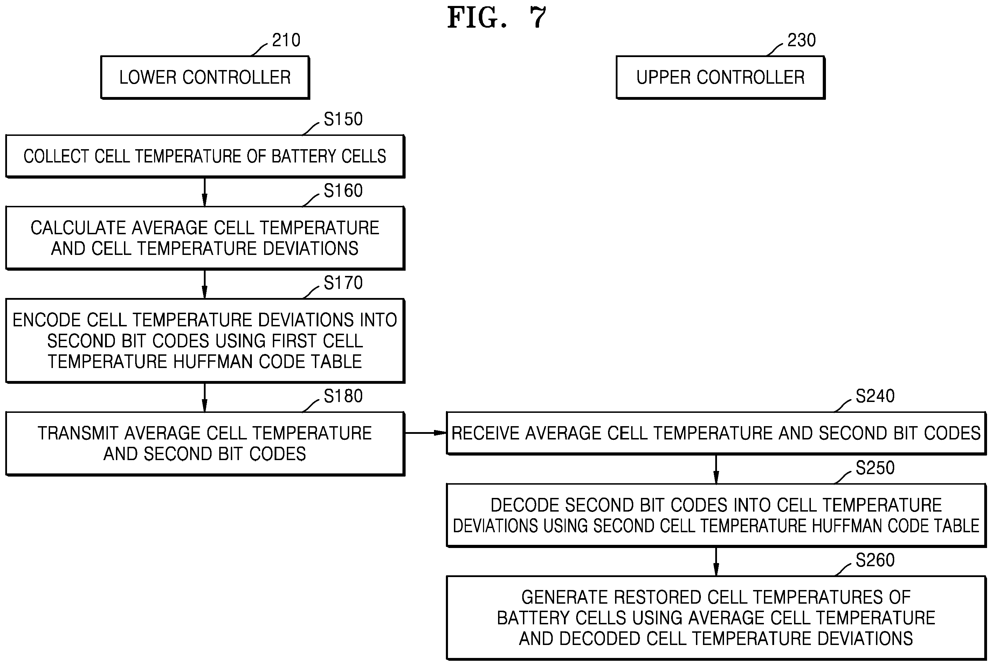

FIG. 6 shows a detailed configuration of a battery management system according to other embodiments. FIG. 7 is a diagram for explaining a method of operating a battery management system according to other embodiments.

Referring to FIGS. 6 and 7, the lower controller 210 and upper controller 230 may perform data communication through the network 201. The network 201 may include a CAN-bus. The lower controller 210 may read data stored in the lower memory 220, and the upper controller 230 may read data stored in the upper memory 240. The lower controller 210 and lower memory 220 may be included in the rack BMS 130 (refer to FIG. 1), and the upper controller 230 and upper memory 240 may be included in the system BMS 110 (refer to FIG. 1).

The lower controller 210 may include a cell voltage collection unit 211, an average cell voltage calculation unit 212, a cell voltage deviation calculation unit 213, a cell voltage deviation encoding unit 214, a transmission unit 215, a cell temperature collection unit 216, an average cell temperature calculation unit 217, a cell temperature deviation calculation unit 218, and a cell temperature deviation encoding unit 219. The lower memory 220 may store a first cell voltage Huffman code table 221 and a first cell temperature Huffman code table 222 in advance.

The cell voltage collection unit 211, the average cell voltage calculation unit 212, the cell voltage deviation calculation unit 213, the cell voltage deviation encoding unit 214, the transmission unit 215 of the lower controller 210 and the first cell voltage Huffman code table 221 stored in the lower memory 220 may be substantially the same as the lower controller 210 and the first cell voltage Huffman code table 221 shown in FIGS. 3 and 4, and thus, the descriptions thereof are omitted.

The upper controller 230 may include a receiving unit 231, a cell voltage deviation decoding unit 232, a cell voltage restoration unit 233, a cell temperature deviation decoding unit 234, and a cell temperature restoration unit 235. The upper memory 240 may store a second cell voltage Huffman code table 241 and a second cell temperature Huffman code table 242 in advance.

The receiving unit 231, the cell voltage deviation decoding unit 232, and the cell voltage restoration unit 233 of the upper controller 230, and the second cell voltage Huffman code table 241 stored in the upper memory 240 may be substantially the same as the upper controller 230 and the second cell voltage Huffman code table 241 shown in FIGS. 3 and 4, and thus, the descriptions thereof are omitted.

The cell temperature collection unit 216 may collect cell temperatures of the battery cells 161 (refer to FIG. 1) at each sampling period (S150). According to one example, the module BMSs 150 (refer to FIG. 1) may measure cell temperatures of the battery cells 161 at each sampling period, and the cell temperature collection unit 216 may receive the cell temperatures of the battery cells 161 from the module BMSs 150 at each sampling period. According to another example, the cell temperature collection unit 216 may directly measure the cell temperatures of the battery cells 161 at each sampling period.

The average cell temperature calculation unit 217 may calculate an average cell temperature based on the cell temperatures of the battery cells 161, and the cell temperature deviation calculation unit 218 may calculate cell temperature deviations of the battery cells 161 by subtracting the average cell temperature from each of the cell temperatures of the battery cells 161 (S160). The cell temperature deviations may be distributed centered zero, e.g., the distribution of cell voltage deviations may be centered at zero. For example, cell temperature deviations may be distributed similar to a Gaussian distribution.

The cell temperature deviation encoding unit 219 may encode the cell temperature deviations into second bit codes by using the first cell temperature Huffman code table 222 stored in the lower memory 220 (S170).

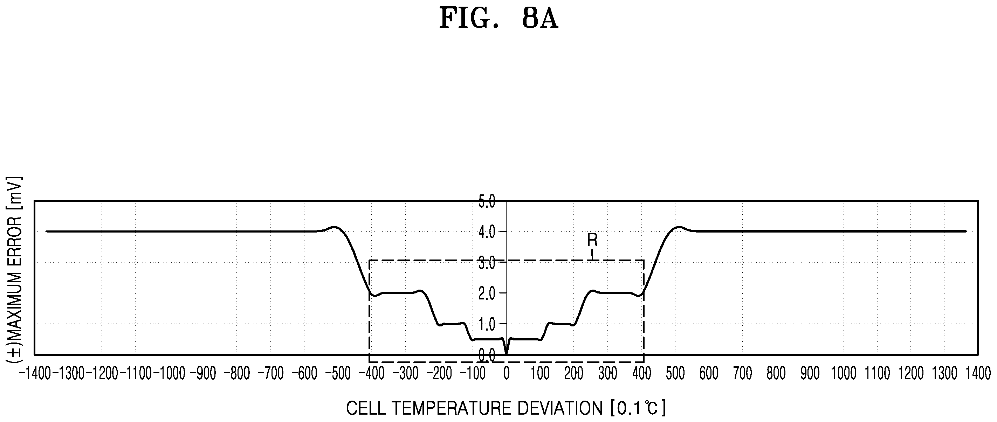

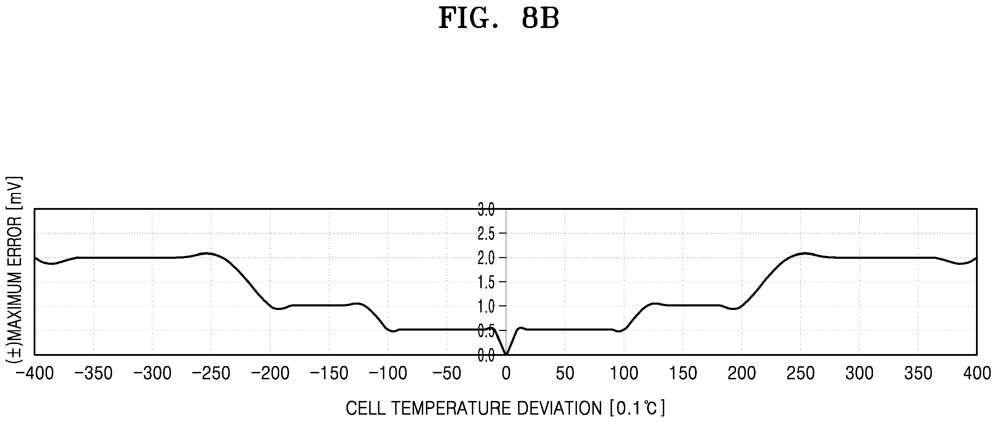

The first cell temperature Huffman code table 222 may be a table in which second bit code values for cell temperature deviation values may be stored and may be configured such that the most frequently occurring cell temperature deviation value corresponds to a short first bit code value. Because the cell temperature deviations may be distributed similarly to a Gaussian distribution, the first bit code value corresponding to a cell temperature deviation value of 0 may be the shortest. As an absolute value of the cell temperature deviation value increases, a length of the first bit code value corresponding to the cell temperature deviation value may become greater. The first cell temperature Huffman code table 222 is described in more detail below with reference to FIGS. 8A and 8B.

The cell temperatures may be expressed in 16 bits. The second bit code may be expressed as 1 bit to several tens of bits. However, because the cell temperature deviations have a distribution similar to a Gaussian distribution, second bit codes encoding cell temperature deviations may be expressed mostly in several bits. If the cell temperature deviations calculated from actual cell temperatures are encoded into second bit codes, the second bit codes may have an average length of 3.47 bits. Because 16-bit cell temperatures may be compressed into 3.47 bit second bit codes, the compression ratio may be approximately 20%.

The transmission unit 215 may transmit the average cell temperature calculated by the average cell temperature calculation unit 217 and the second bit codes generated by the cell temperature deviation encoding unit 219 to the upper controller 230 (S180).

The receiving unit 231 may receive the cell temperature average and second bit codes from the lower controller 210 (S240).

The cell temperature deviation decoding unit 234 may decode the second bit codes into cell temperature deviations by using the second cell temperature Huffman code table 242 stored in the upper memory 240 (S250). The first and second cell temperature Huffman code tables 222 and 242 may store the same second bit code for cell temperature deviation as each other.

The cell temperature deviations generated by decoding the second bit codes the cell temperature deviation decoding unit 234 may mostly exactly match the cell temperature deviations calculated from the cell temperatures of the battery cells 161 by the cell temperature deviation calculation unit 218, but some may have slight errors.

The cell temperature restoration unit 235 may generate restored cell temperatures of the plurality of battery cells 161 by using the average cell temperature and the decoded cell temperature deviations (S260). As described above, most of the recovery cell temperatures of the battery cells 161 may be the same as the cell temperatures of the battery cells 161, and some restored cell temperatures may have a slight error with the cell temperatures of the battery cells 161. However, this error may be small and below a preset maximum error.

The size of data to be transmitted may be greatly reduced by encoding the cell temperature deviations into second bit codes and transmitting them instead of transmitting the cell temperature values as is. For example, when 99 cell temperature values are directly transmitted, data of 1.584 kbit may be transmitted at each sampling period, but according to the present disclosure, if the second bit codes are encoded and transmitted using the cell temperature Huffman code tables 222 and 242, data of 360 bits may be compressed and transmitted at each sampling period.

Because the size of data to be transmitted may be reduced by approximately 23%, the sampling period may be reduced 0.23 times even if the transmission speed is maintained. That is, if the sampling period was 10 msec, the sampling period may be reduced to 2.3 msec according to the present disclosure. According to another example, if the number of battery racks 120 included in the battery system 100 was 6, according to the present disclosure, the number of battery racks 120 included in the battery system 100 may be increased to 25.

FIG. 8A is a diagram showing characteristics of a cell temperature Huffman code table used in a battery management system according to embodiments, and FIG. 8B is an enlarged view of a portion R of FIG. 8A.

Referring to FIGS. 8A and 8B, a maximum error for cell temperature deviation, which may be a characteristic of the cell temperature Huffman code table, is shown. The cell temperature Huffman code tables 222 and 242 may be configured such that the maximum error remains the same or increases as the absolute value of the cell temperature deviation increases.

If the absolute value of the cell temperature deviation exceeds the above reference value, a certain error may occur between the cell temperature deviation value calculated by the cell temperature deviation calculation unit 218 and the cell temperature deviation value generated by the cell temperature deviation decoding unit 234, but the size of the error may be less than the maximum error.

A lossless compression may be achieved if the cell temperature deviation is zero. If the cell temperature deviation is -10 °C to 10 °C, the maximum error between the cell temperature and the restored cell temperature may be 0.5 °C. In addition, if the cell temperature deviation is -20 °C to -10 °C or 10 °C to 20 °C, the maximum error between the cell temperature and the restored cell temperature may be 1 °C. The first and second cell temperature Huffman code tables 222 and 242 may be symmetrically configured such that the maximum error may be the same or increases as the absolute value of the cell temperature deviation increases.

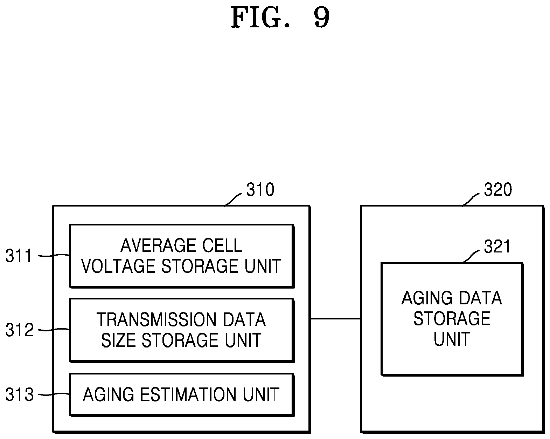

FIG. 9 is a diagram showing a detailed configuration of a battery management system according to other embodiments.

Referring to FIG. 9, a controller 310 and a memory 320 are shown. The controller 310 may include an average cell voltage storage unit 311, a transmission data size storage unit 312, and an aging estimation unit 313. The memory 320 may include an aging data storage unit 321.

The controller 310 may be a lower controller 210 (refer to FIG. 3) or an upper controller 230 (refer to FIG. 3). The memory 320 may also be a lower memory 220 (refer to FIG. 3) or an upper memory 240 (refer to FIG. 3). According to another example, the lower controller 210 and the upper controller 230 may include the average cell voltage storage unit 311, the transmission data size storage unit 312, and the aging estimation unit 313, respectively. The controller 310 may sense the cell voltages of the plurality of battery cells 161 at each sampling period of the plurality of sampling periods and may transmit sensed cell voltages to the lower controller 210.

As described above with reference to FIGS. 3 and 4, the lower controller 210 may transmit an average cell voltage and first bit codes to the upper controller 230 at each sampling period. The average cell voltage may be calculated based on the cell voltages of the battery cells 161 by the average cell voltage calculation unit 212, and the first bit codes may be generated by the cell voltage deviation encoding unit 214 by encoding the cell voltage deviations, which may be calculated by the cell voltage deviation calculation unit 213.

The average cell voltage storage unit 311 may store the average cell voltage transmitted at each sampling period in the aging data storage unit 321. The transmission data size storage unit 312 may store the size of transmission data transmitted at each sampling period in the aging data storage unit 321. The transmission data may include first bit codes. The transmission data may include both the average cell voltage and the first bit codes transmitted at each sampling period.

If the battery cells 161 are fresh, cell voltages may be uniform, but as the battery cells 161 age, the cell voltages may become relatively non-uniform. If the cell voltages of the battery cells 161 are low, the cell voltages may be distributed somewhat widely.

If encoding cell voltage deviations into first bit codes using the Huffman code table according to the present disclosure, if the cell voltages are uniform, the cell voltage deviations may be encoded into first bit codes having a short length, but as cell voltages become more non-uniform, cell voltage deviations having large absolute values may be encoded into first bit codes having long lengths, and thus the total length of the first bit codes may become greater.

The aging estimation unit 313 may use these characteristics to estimate the aging degree of the battery 160 based on the size of the transmitted data. For example, the aging estimation unit 313 may extract, from the aging data storage unit 321, transmitted data sizes if the average cell voltage is greater than a reference value, and may estimate the degree of aging based on an average size of a predetermined number of recently transmitted data sizes among the extracted transmission data sizes.
A first transmission data size when the battery cells 161 are fresh and a second transmission data size when the battery cells 161 age may be stored in advance in the aging data storage unit 321. The aging estimation unit 313 may estimate the degree of aging of the battery 160 by comparing the average size of a predetermined number of recently transmitted data with sizes of the first transmitted data and the second transmitted data. According to the present invention, at least one of the upper controller 230 and the lower controller 210 is configured to estimate, based on a size of transmission data including the first bit codes at each sampling period of the plurality of sampling periods, a degree of aging of the plurality of battery cells 161.

According to the present disclosure, not only the size of data exchanged between controllers of a battery management system may be reduced, but also the aging degree of the battery may be estimated based on the size of the transmitted data.

In the battery system according to various embodiments, the lower controller may compress cell data using the Huffman algorithm and transmit the cell data to the upper controller, and thus, the sampling period may be kept short despite the increased number of battery cells and limited transmission speed. To increase transmission speed, transmission lines may not be increased and highspeed communication devices may not be installed.

According to various embodiments, not only the size of data exchanged between controllers of a battery management system may be reduced, but also the aging degree of the battery may be estimated based on the size of the transmitted data.

By way of summation and review, as driving range becomes an important purchasing factor for electric vehicles, larger-capacity battery packs may be installed in electric vehicles. Accordingly, the number of battery cells mounted on a battery pack may increase.

In order to manage battery cells reliably, battery systems such as energy storage systems or electric vehicle battery packs may be structured hierarchically. In a battery system, a lower controller may measure voltage and temperature of battery cells and transmit the measurements to an upper controller. As the number of battery cells increases, there may be cases in which the size of data to be transmitted to the upper controller exceeds the transmission speed.

One or more embodiments may include a battery system that compresses and transmits data collected from battery cells, and a method of operating a battery management system.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated.

## Claims

1. A battery system (100) comprising:
a plurality of battery cells (161); **characterized by**
a lower controller (210) configured to collect cell voltages of the plurality of battery cells (161) at each sampling period of a plurality of sampling periods, calculate, based on the cell voltages, an average cell voltage and cell voltage deviations, encode the cell voltage deviations into first bit codes by using a first cell voltage Huffman code table (221), and transmit the average cell voltage and the first bit codes at each sampling period of the plurality of sampling periods; and
an upper controller (230) configured to receive the average cell voltage and the first bit codes from the lower controller (210), decode the first bit codes into decoded cell voltage deviations by using a second cell voltage Huffman code table (241), and generate restored cell voltages of the plurality of battery cells (161) by using the average cell voltage and the decoded cell voltage deviations,
whereby at least one of the upper controller (230) and the lower controller (210) is configured to estimate, based on a size of transmission data including the first bit codes at each sampling period of the plurality of sampling periods, a degree of aging of the plurality of battery cells (161).

2. The battery system (100) of claim 1, further comprising:
a lower memory (220) in which the first cell voltage Huffman code table (221) readable by the lower controller (210) is stored in advance; and
an upper memory (240) in which the second cell voltage Huffman code table (241) readable by the upper controller (230) is stored in advance.

3. The battery system (100) of claim 1 or 2, further comprising a controller (310) configured to sense the cell voltages of the plurality of battery cells (161) at each sampling period of the plurality of sampling periods and transmit sensed cell voltages to the lower controller (210).

4. The battery system (100) of any of claims 1 to 3, wherein the first cell voltage Huffman code table (221) and the second cell voltage Huffman code table (241) store a same first bit code for a cell voltage deviation as each other.

5. The battery system (100) of claim 4, wherein the first and second cell voltage Huffman code tables (221, 241) are such that a maximum error is the same or increases as an absolute value of the cell voltage deviation increases.

6. The battery system (100) of claim 5, wherein the first and second cell voltage Huffman code tables (221, 241) are configured to perform lossless compression if the cell voltage deviation is between a first reference value less than 0 and a second reference value greater than 0.

7. The battery system (100) of claim 5, wherein the first and second cell voltage Huffman code tables (221, 241) are asymmetrical such that a speed at which the maximum error increases on average if the cell voltage deviation is less than 0 is slower than a speed at which the maximum error increases on average if the cell voltage deviation is greater than 0.

8. The battery system (100) of any of claims 1 to 7, wherein the lower controller (210) is configured to collect cell temperatures of the plurality of battery cells (161) at each sampling period of the plurality of sampling periods, calculate, based on the cell temperatures, an average cell temperature and cell temperature deviations, encode the cell temperature deviations into second bit codes by using a first cell temperature Huffman code table (222), and transmit the average cell temperature and the second bit codes to the upper controller (230) at each sampling period of the plurality of sampling periods, and
the upper controller (230) is configured to receive the average cell temperature and the second bit codes from the lower controller (210), decode the second bit codes into decoded cell temperature deviations by using the second cell temperature Huffman code table (242), and generate restored cell temperatures of the plurality of battery cells (161) by using the average cell temperature and the decoded cell temperature deviations.

9. The battery system (100) of claim 8, further comprising:
a lower memory (220) in which the first cell temperature Huffman code table (222) readable by the lower controller (210) is stored in advance; and
an upper memory (240) in which the second cell temperature Huffman code table (242) readable by the upper controller (230) is stored in advance.

10. The battery system (100) of claim 8, wherein the first cell temperature Huffman code table (222) and the second cell temperature Huffman code table (242) store a same second bit code for a cell temperature deviation as each other.

11. The battery system (100) of claim 10, wherein the first and second cell temperature Huffman code tables (222, 242) are symmetrical such that a maximum error is the same or increases as an absolute value of the cell temperature deviation increases.

12. An operating method of a battery management system (100) including a lower controller (210) and an upper controller (230), the method comprising:
collecting, by the lower controller (210), cell voltages of a plurality of battery cells (161) at each sampling period of a plurality of sampling periods; **characterized by**
based on the cell voltages, calculating, by the lower controller (210), an average cell voltage and cell voltage deviations;
encoding, by the lower controller (210), the cell voltage deviations into first bit codes by using a first cell voltage Huffman code table (221) stored in advance;
transmitting, by the lower controller (210), the average cell voltage and the first bit codes to the upper controller (230) at each sampling period of a plurality of sampling periods;
receiving, by the upper controller (230), the average cell voltage and the first bit codes from the lower controller (210);
decoding, by the upper controller (230), the first bit codes into decoded cell voltage deviations by using a second cell voltage Huffman code table (241) stored in advance; and
generating, by the upper controller (230), restored cell voltages of the plurality of battery cells (161) by using the average cell voltage and the decoded cell voltage deviations at each sampling period,
whereby at least one of the upper controller (230) or the lower controller (210):
stores the average cell voltage at each sampling period;
stores a size of transmission data including the first bit codes at each sampling period of the plurality of sampling periods; and
estimates a degree of aging of the plurality of battery cells (161), based on the size of the transmission data.

13. The method of claim 12, further comprising:
collecting, by the lower controller (210), cell temperatures of the plurality of battery cells (161) at each sampling period of the plurality of sampling periods;
based on the cell temperatures, calculating, by the lower controller (210), an average cell temperature and cell temperature deviations;
encoding, by the lower controller (210), the cell temperature deviations into second bit codes by using the first cell temperature Huffman code table (222) stored in advance;
transmitting, by the lower controller (210), the average cell temperature and the second bit codes to the upper controller (230) at each sampling period of the plurality of sampling periods;
receiving, by the upper controller (230), the average cell temperature and the second bit codes from the lower controller (210);
decoding, by the upper controller (230), the second bit codes into decoded cell temperature deviations by using the second cell temperature Huffman code table (242) stored in advance; and
generating, by the upper controller (230), restored cell temperatures of the plurality of battery cells (161) by using the average cell temperature and the decoded cell temperature deviations for each sampling period.

## Patentansprüche

1. Batteriesystem (100), umfassend:
mehrere Batteriezellen (161); **gekennzeichnet durch**
eine untere Steuerung (210), die dazu konfiguriert ist, Zellenspannungen der mehreren Batteriezellen (161) in jedem Abtastzeitraum von mehreren Abtastzeiträumen zu sammeln, auf der Grundlage der Zellenspannungen eine durchschnittliche Zellenspannung und Zellenspannungsabweichungen zu berechnen, die Zellenspannungsabweichungen unter Verwendung einer ersten Zellenspannungs-Huffman-Codetabelle (221) in erste Bitcodes zu codieren und die durchschnittliche Zellenspannung und die ersten Bitcodes in jedem Abtastzeitraum der mehreren Abtastzeiträume zu übertragen; und
eine obere Steuerung (230), die dazu konfiguriert ist, die durchschnittliche Zellenspannung und die ersten Bitcodes von der unteren Steuerung (210) zu empfangen, die ersten Bitcodes unter Verwendung einer zweiten Zellenspannungs-Huffman-Codetabelle (241) in decodierte Zellenspannungsabweichungen zu decodieren und wiederhergestellte Zellenspannungen der mehreren Batteriezellen (161) unter Verwendung der durchschnittlichen Zellenspannung und der decodierten Zellenspannungsabweichungen zu erzeugen,
wobei
mindestens eine von der oberen Steuerung (230) und der unteren Steuerung (210) dazu konfiguriert ist, auf der Grundlage einer Größe von Übertragungsdaten, die die ersten Bitcodes in jedem Abtastzeitraum der mehreren Abtastzeiträume enthalten, einen Alterungsgrad der mehreren Batteriezellen (161) zu schätzen.

2. Batteriesystem (100) nach Anspruch 1, umfassend ferner:
einen unteren Speicher (220), in dem die erste Zellenspannungs-Huffman-Codetabelle (221), die von der unteren Steuerung (210) gelesen werden kann, im Voraus gespeichert ist; und
einen oberen Speicher (240), in dem die zweite Zellenspannungs-Huffman-Codetabelle (241), die von der oberen Steuerung (230) gelesen werden kann, im Voraus gespeichert ist.

3. Batteriesystem (100) nach Anspruch 1 oder 2, umfassend ferner eine Steuerung (310), die dazu konfiguriert ist, die Zellenspannungen der mehreren Batteriezellen (161) in jedem Abtastzeitraum der mehreren Abtastzeiträume zu erfassen und die erfassten Zellenspannungen an die untere Steuerung (210) zu übertragen.

4. Batteriesystem (100) nach einem der Ansprüche 1 bis 3, wobei die erste Zellenspannungs-Huffman-Codetabelle (221) und die zweite Zellenspannungs-Huffman-Codetabelle (241) denselben ersten Bitcode für eine Zellenspannungsabweichung speichern.

5. Batteriesystem (100) nach Anspruch 4, wobei die erste und die zweite Zellenspannungs-Huffman-Codetabelle (221, 241) so beschaffen sind, dass ein maximaler Fehler gleich bleibt oder zunimmt, wenn ein Absolutwert der Zellenspannungsabweichung zunimmt.

6. Batteriesystem (100) nach Anspruch 5, wobei die erste und die zweite Zellenspannungs-Huffman-Codetabelle (221, 241) so konfiguriert sind, dass sie eine verlustfreie Komprimierung durchführen, wenn die Zellenspannungsabweichung zwischen einem ersten Referenzwert kleiner als 0 und einem zweiten Referenzwert größer als 0 liegt.

7. Batteriesystem (100) nach Anspruch 5, wobei die erste und die zweite Zellenspannungs-Huffman-Codetabelle (221, 241) asymmetrisch sind, so dass die Geschwindigkeit, mit der der maximale Fehler im Durchschnitt zunimmt, wenn die Zellenspannungsabweichung kleiner als 0 ist, langsamer ist als die Geschwindigkeit, mit der der maximale Fehler im Durchschnitt zunimmt, wenn die Zellenspannungsabweichung größer als 0 ist.

8. Batteriesystem (100) nach einem der Ansprüche 1 bis 7, wobei die untere Steuerung (210) dazu konfiguriert ist, Zellentemperaturen der mehreren Batteriezellen (161) in jedem Abtastzeitraum der mehreren Abtastzeiträume zu sammeln, auf der Grundlage der Zellentemperaturen eine durchschnittliche Zellentemperatur und Zellentemperaturabweichungen zu berechnen, die Zellentemperaturabweichungen unter Verwendung einer ersten Zellentemperatur-Huffman-Codetabelle (222) in zweite Bitcodes zu codieren und die durchschnittliche Zellentemperatur und die zweiten Bitcodes in jedem Abtastzeitraum der mehreren Abtastzeiträume an die obere Steuerung (230) zu übertragen, und
die obere Steuerung (230) dazu konfiguriert ist, die durchschnittliche Zellentemperatur und die zweiten Bitcodes von der unteren Steuerung (210) zu empfangen, die zweiten Bitcodes unter Verwendung der zweiten Zellentemperatur-Huffman-Codetabelle (242) in decodierte Zellentemperaturabweichungen zu decodieren und unter Verwendung der durchschnittlichen Zellentemperatur und der decodierten Zellentemperaturabweichungen wiederhergestellte Zellentemperaturen der mehreren Batteriezellen (161) zu erzeugen.

9. Batteriesystem (100) nach Anspruch 8, umfassend ferner:
einen unteren Speicher (220), in dem die erste Zellentemperatur-Huffman-Codetabelle (222), die von der unteren Steuerung (210) gelesen werden kann, im Voraus gespeichert ist; und
einen oberen Speicher (240), in dem die zweite Zellentemperatur-Huffman-Codetabelle (242), die von der oberen Steuerung (230) gelesen werden kann, im Voraus gespeichert ist.

10. Batteriesystem (100) nach Anspruch 8, wobei die erste Zellentemperatur-Huffman-Codetabelle (222) und die zweite Zellentemperatur-Huffman-Codetabelle (242) denselben zweiten Bitcode für eine Zellentemperaturabweichung speichern.

11. Batteriesystem (100) nach Anspruch 10, wobei die erste und die zweite Zellentemperatur-Huffman-Codetabelle (222, 242) symmetrisch sind, so dass ein maximaler Fehler gleich bleibt oder mit steigendem Absolutwert der Zellentemperaturabweichung zunimmt.

12. Verfahren zum Betreiben eines Batteriemanagementsystems (100) mit einer unteren Steuerung (210) und einer oberen Steuerung (230), wobei das Verfahren Folgendes umfasst:
Sammeln von Zellenspannungen mehrerer Batteriezellen (161) durch die untere Steuerung (210) in jedem Abtastzeitraum von mehreren Abtastzeiträumen; **gekennzeichnet durch**
Berechnen einer durchschnittlichen Zellenspannung und von Zellenspannungsabweichungen durch die untere Steuerung (210) auf der Grundlage der Zellenspannungen;
Codieren der Zellenspannungsabweichungen durch die untere Steuerung (210) in erste Bitcodes unter Verwendung einer im Voraus gespeicherten ersten Zellenspannungs-Huffman-Codetabelle (221);
Übertragen der durchschnittlichen Zellenspannung und der ersten Bitcodes durch die untere Steuerung (210) an die obere Steuerung (230) in jedem Abtastzeitraum von mehreren Abtastzeiträumen;
Empfangen der durchschnittlichen Zellenspannung und der ersten Bitcodes von der unteren Steuerung (210) durch die obere Steuerung (230);
Decodieren der ersten Bitcodes durch die obere Steuerung (230) in decodierte Zellenspannungsabweichungen unter Verwendung einer im Voraus gespeicherten zweiten Zellenspannungs-Huffman-Codetabelle (241); und
Erzeugen wiederhergestellter Zellenspannungen der mehreren Batteriezellen (161) durch die obere Steuerung (230) unter Verwendung der durchschnittlichen Zellenspannung und der decodierten Zellenspannungsabweichungen in jedem Abtastzeitraum,
wobei
mindestens eine von der oberen Steuerung (230) und der unteren Steuerung (210): die durchschnittliche Zellenspannung in jedem Abtastzeitraum speichert;
eine Größe von Übertragungsdaten, die die ersten Bitcodes umfassen, in jedem Abtastzeitraum der mehreren Abtastzeiträume speichert; und
einen Alterungsgrad der mehreren Batteriezellen (161) auf der Grundlage der Größe der Übertragungsdaten schätzt.

13. Verfahren nach Anspruch 12, umfassend ferner:
Sammeln von Zellentemperaturen der mehreren Batteriezellen (161) durch die untere Steuerung (210) in jedem Abtastzeitraum der mehreren Abtastzeiträume;
Berechnen einer durchschnittlichen Zellentemperatur und von Zellentemperaturabweichungen durch die untere Steuerung (210) auf der Grundlage der Zellentemperaturen;
Codieren der Zellentemperaturabweichungen durch die untere Steuerung (210) in zweite Bitcodes unter Verwendung der im Voraus gespeicherten ersten Zellentemperatur-Huffman-Codetabelle (222);
Übertragen der durchschnittlichen Zellentemperatur und der zweiten Bitcodes durch die untere Steuerung (210) an die obere Steuerung (230) in jedem Abtastzeitraum der mehreren Abtastzeiträume;
Empfangen der durchschnittlichen Zellentemperatur und der zweiten Bitcodes von der unteren Steuerung (210) durch die obere Steuerung (230);
Decodieren der zweiten Bitcodes durch die obere Steuerung (230) in decodierte Zellentemperaturabweichungen unter Verwendung der im Voraus gespeicherten zweiten Zellentemperatur-Huffman-Codetabelle (242); und
Erzeugen wiederhergestellter Zellentemperaturen der mehreren Batteriezellen (161) durch die obere Steuerung (230) unter Verwendung der durchschnittlichen Zellentemperatur und der decodierten Zellentemperaturabweichungen für jeden Abtastzeitraum.

## Revendications

1. Système de batterie (100) comportant :
une pluralité de cellules de batterie (161) ; **caractérisé par**
un dispositif de commande inférieur (210) configuré pour collecter des tensions de cellule de la pluralité de cellules de batterie (161) à chaque période d'échantillonnage d'une pluralité de périodes d'échantillonnage, calculer, sur la base des tensions de cellule, une tension de cellule moyenne et des écarts de tension de cellule, coder les écarts de tension de cellule en premiers codes binaires en utilisant une première table de codage de Huffman de tension de cellule (221), et transmettre la tension de cellule moyenne et les premiers codes binaires à chaque période d'échantillonnage de la pluralité de périodes d'échantillonnage ; et
un dispositif de commande supérieur (230) configuré pour recevoir la tension de cellule moyenne et les premiers codes binaires du dispositif de commande inférieur (210), décoder les premiers codes binaires en écarts de tension de cellule décodés en utilisant une seconde table de codage de Huffman de tension de cellule (241), et générer des tensions de cellule restaurées de la pluralité de cellules de batterie (161) en utilisant la tension de cellule moyenne et les écarts de tension de cellule décodés,
moyennant quoi au moins l'un parmi le dispositif de commande supérieur (230) et le dispositif de commande inférieur (210) est configuré pour estimer, sur la base d'une taille de données de transmission incluant les premiers codes binaires à chaque période d'échantillonnage de la pluralité de périodes d'échantillonnage, un degré de vieillissement de la pluralité de cellules de batterie (161).

2. Système de batterie (100) selon la revendication 1, comportant en outre :
une mémoire inférieure (220) dans laquelle la première table de codage de Huffman de tension de cellule (221) lisible par le dispositif de commande inférieur (210) est stockée à l'avance ; et
une mémoire supérieure (240) dans laquelle la seconde table de codage de Huffman de tension de cellule (241) lisible par le dispositif de commande supérieur (230) est stockée à l'avance.

3. Système de batterie (100) selon la revendication 1 ou 2, comportant en outre un dispositif de commande (310) configuré pour détecter les tensions de cellule de la pluralité de cellules de batterie (161) à chaque période d'échantillonnage de la pluralité de périodes d'échantillonnage et transmettre les tensions de cellule détectées au dispositif de commande inférieur (210).

4. Système de batterie (100) selon l'une quelconque des revendications 1 à 3, dans lequel la première table de codage de Huffman de tension de cellule (221) et la seconde table de codage de Huffman de tension de cellule (241) stockent un même premier code binaire pour un écart de tension de cellule l'une par rapport à l'autre.

5. Système de batterie (100) selon la revendication 4, dans lequel les première et seconde tables de codage de Huffman de tension de cellule (221, 241) sont telles qu'une erreur maximale est la même ou augmente à mesure qu'une valeur absolue de l'écart de tension de cellule augmente.

6. Système de batterie (100) selon la revendication 5, dans lequel les première et seconde tables de codage de Huffman de tension de cellule (221, 241) sont configurées pour effectuer une compression sans perte si l'écart de tension de cellule est comprise entre une première valeur de référence inférieure à 0 et une seconde valeur de référence supérieure à 0.

7. Système de batterie (100) selon la revendication 5, dans lequel les première et seconde tables de codage de Huffman de tension de cellule (221, 241) sont asymétriques de sorte qu'une vitesse à laquelle l'erreur maximale augmente en moyenne si l'écart de tension de cellule est inférieur à 0 est plus lente qu'une vitesse à laquelle l'erreur maximale augmente en moyenne si l'écart de tension de cellule est supérieur à 0.

8. Système de batterie (100) selon l'une quelconque des revendications 1 à 7, dans lequel le dispositif de commande inférieur (210) est configuré pour collecter des températures de cellule de la pluralité de cellules de batterie (161) à chaque période d'échantillonnage de la pluralité de périodes d'échantillonnage, calculer, sur la base des températures de cellule, une température de cellule moyenne et des écarts de température de cellule, coder les écarts de température de cellule en seconds codes binaires en utilisant une première table de codage de Huffman de température de cellule (222), et transmettre la température de cellule moyenne et les seconds codes binaires au dispositif de commande supérieur (230) à chaque période d'échantillonnage de la pluralité de périodes d'échantillonnage, et
le dispositif de commande supérieur (230) est configuré pour recevoir la température de cellule moyenne et les seconds codes binaires du dispositif de commande inférieur (210), décoder les seconds codes binaires en écarts de température de cellule décodés en utilisant la seconde table de codage de Huffman de température de cellule (242) et générer des températures de cellule restaurées de la pluralité de cellules de batterie (161) en utilisant la température de cellule moyenne et les écarts de température de cellule décodés.

9. Système de batterie (100) selon la revendication 8, comportant en outre :
une mémoire inférieure (220) dans laquelle la première table de codage de Huffman de température de cellule (222) lisible par le dispositif de commande inférieur (210) est stockée à l'avance ; et
une mémoire supérieure (240) dans laquelle la seconde table de codage de Huffman de température de cellule (242) lisible par le dispositif de commande supérieur (230) est stockée à l'avance.

10. Système de batterie (100) selon la revendication 8, dans lequel la première table de codage de Huffman de température de cellule (222) et la seconde table de codage de Huffman de température de cellule (242) stockent un même second code binaire pour un écart de température de cellule l'une par rapport à l'autre.

11. Système de batterie (100) selon la revendication 10, dans lequel les première et seconde tables de codage de Huffman de température de cellule (222, 242) sont symétriques de sorte qu'une erreur maximale est la même ou augmente à mesure qu'une valeur absolue de l'écart de température de cellule augmente.

12. Procédé de fonctionnement d'un système de gestion de batterie (100) incluant un dispositif de commande inférieur (210) et un dispositif de commande supérieur (230), le procédé comportant :
la collecte, par le dispositif de commande inférieur (210), de tensions de cellules d'une pluralité de cellules de batterie (161) à chaque période d'échantillonnage d'une pluralité de périodes d'échantillonnage ; **caractérisé par**
sur la base des tensions de cellule, le calcul, par le dispositif de commande inférieur (210), d'une tension de cellule moyenne et d'écarts de tension de cellule ;
le codage, par le dispositif de commande inférieur (210), des écarts de tension de cellule en premiers codes binaires en utilisant une première table de codage de Huffman de tension de cellule (221) stockée à l'avance ;
la transmission, par le dispositif de commande inférieur (210), de la tension de cellule moyenne et des premiers codes binaires au dispositif de commande supérieur (230) à chaque période d'échantillonnage d'une pluralité de périodes d'échantillonnage ;
la réception, par le dispositif de commande supérieur (230), de la tension de cellule moyenne et des premiers codes binaires en provenance du dispositif de commande inférieur (210) ;
le décodage, par le dispositif de commande supérieur (230), des premiers codes binaires en écarts de tension de cellule décodés en utilisant une seconde table de codage de Huffman de tension de cellule (241) stockée à l'avance ; et
la génération, par le dispositif de commande supérieur (230), de tensions de cellule restaurées de la pluralité de cellules de batterie (161) en utilisant la tension de cellule moyenne et les écarts de tension de cellule décodés à chaque période d'échantillonnage,
moyennant quoi au moins l'un parmi le dispositif de commande supérieur (230) ou le dispositif de commande inférieur (210) :
stocke la tension de cellule moyenne à chaque période d'échantillonnage ;
stocke une taille de données de transmission incluant les premiers codes binaires à chaque période d'échantillonnage de la pluralité de périodes d'échantillonnage ; et
estime un degré de vieillissement de la pluralité de cellules de batterie (161), sur la base de la taille des données de transmission.

13. Procédé selon la revendication 12, comportant en outre :
la collecte, par le dispositif de commande inférieur (210), de températures de cellule de la pluralité de cellules de batterie (161) à chaque période d'échantillonnage de la pluralité de périodes d'échantillonnage ;
sur la base des températures de cellule, le calcul, par le dispositif de commande inférieur (210), d'une température de cellule moyenne et d'écarts de température de cellule ;
le codage, par le dispositif de commande inférieur (210), des écarts de température de cellule en seconds codes binaires en utilisant la première table de codage de Huffman de température de cellule (222) stockée à l'avance ;
la transmission, par le dispositif de commande inférieur (210), de la température de cellule moyenne et des seconds codes binaires au dispositif de commande supérieur (230) à chaque période d'échantillonnage de la pluralité de périodes d'échantillonnage ;
la réception, par le dispositif de commande supérieur (230), de la température de cellule moyenne et des seconds codes binaires en provenance du dispositif de commande inférieur (210) ;
le décodage, par le dispositif de commande supérieur (230), des seconds codes binaires en écarts de température de cellule décodés en utilisant la seconde table de codage de Huffman de température de cellule (242) stockée à l'avance ; et
la génération, par le dispositif de commande supérieur (230), de températures de cellule restaurées de la pluralité de cellules de batterie (161) en utilisant la température de cellule moyenne et les écarts de température de cellule décodés pour chaque période d'échantillonnage.
